# EUROPEAN PATENT SPECIFICATION

(11) **EP 4 567 883 B1**
(45) Date of publication and mention of the grant of the patent: **07.10.2026**
(21) Application number: 24169902.4
(22) Date of filing: 12.04.2024
(51) Int. Cl.: H10W 70/40, H02M 7/00, H10W 74/10, H10W 90/10, H10W 90/00

(54) **DRIVING DEVICE**
ANTRIEBSVORRICHTUNG
DISPOSITIF D'ENTRAÎNEMENT

(30) Priority: 07.12.2023 TW 112147678
(43) Date of publication of application: 11.06.2025
(73) Proprietor: Actron Technology Corporation, Taoyuan City 338 (TW)
(72) Inventor: HSIAO, Pen-Hung, 338 Taoyuan City (TW); CHEN, Wei-Jung, 338 Taoyuan City (TW)
(74) Representative: Melchior, Robin

(56) References cited:
- JP-A- 2006 216 989
- US-B2- 11 476 183

## Description

### BACKGROUND OF THE INVENTION

### Technical Field

The present invention relates generally to a driving device, and more particularly to a driving device with a built-in package.

### Description of Related Art

A power module of a conventional driving device is connected to a three-phase motor to drive the three-phase motor, as disclosed in US Patent Publication No. US11476183B2 and JP Patent Application No. JP2006216989A. For example, the US Patent Publication No. US11476183B2 discloses a "Semiconductor package", wherein a power module is constituted of a plurality of driving circuits 3a, 3b, 3c, 4a, 4b, 4c and a plurality of switching units 1a, 1b, 1c, 1d, 1e, 1f. The driving circuits 3a, 3b, 3c, 4a, 4b, 4c include three high-side driving circuits 3a, 3b, 3c and three low-side driving circuits 4a, 4b, 4c. The switching units 1a, 1b, 1c, 1d, 1e, 1f include three high-side switching units 1a, 1b, 1c and three low-side switching units 1d, 1e, 1f. By the packaging technique of package in package (PiP), the three high-side driving circuits 3a, 3b, 3c are packaged in a built-in package 5 to form a high-side driving unit that is monolithic. The high-side driving unit is connected to the high-side switching units 1a, 1b, 1c through a plurality of wires 7a, 7b, 7c by bonding. Then the power module is packaged by an outer package 8.

The built-in package 5 could simultaneously package the three high-side driving circuits 3a, 3b, 3c. The high-side driving unit packaged by the built-in package 5 could be inspected in advance. However, when any one of the high-side driving circuits 3a, 3b, 3c of the high-side driving unit is found malfunctioned during inspection, the entire high-side driving unit packaged by the built-in package 5 is required to be replaced even if the other two high-side driving circuits 3a, 3b, 3c function properly, so that the overall cost is increased Moreover, as three high-side driving circuits 3a, 3b, 3c of the high-side driving unit are integrally packaged, the yield rate of packaging is decreased and the packaging time is increased.

Therefore, the conventional driving module still has room for improvement. How to reduce the cost due to malfunction and increase the yield rate, has become a major issue in the industry.

### SUMMARY OF THE INVENTION

In view of the above, the primary objective of the present invention is to provide a driving device, which could reduce a cost due to malfunction and increase a yield rate.

The present invention provides a driving device, including a lead frame, a plurality of high-side driving modules, at least one low-side driving module, a plurality of high-side switching modules, a plurality of low-side switching modules, and an outer package. The lead frame has a plurality of high-side driving regions, at least one low-side driving region, a plurality of high-side switching regions, and a plurality of low-side switching regions. The high-side driving modules are respectively disposed in the high-side driving regions of the lead frame. Each of the high-side driving modules includes a built-in package, a primary-side circuit, a drive-side circuit, and a bootstrap diode. The built-in package packages the primary-side circuit, the drive-side circuit, and the bootstrap diode. The built-in package has a top surface and a bottom surface. The bottom surface is provided with a plurality of leads. The leads are electrically connected to the primary-side circuit, the drive-side circuit, and the bootstrap diode. The bottom surface of each of the high-side driving modules faces each of the high-side driving regions of the lead frame. The leads of each of the high-side driving modules are welded to each of the high-side driving regions of the lead frame. The at least one low-side driving module is disposed in the at least one low-side driving region of the lead frame. The high-side switching modules are respectively disposed in the high-side switching regions of the lead frame. Each of the high-side switching modules are electrically connected to each of the high-side driving modules through the lead frame. The low-side switching modules are respectively disposed in the low-side switching regions of the lead frame. The low-side switching modules are electrically connected to the at least one low-side driving module through the lead frame. The outer package packages the high-side driving modules, the at least one low-side driving module, the high-side switching modules, the low-side switching modules, and the lead frame.

With the aforementioned design, each of the high-side driving modules includes the built-in package to package the primary-side circuit, the drive-side circuit, and the bootstrap diode, so that each of the high-side driving modules forms an individual component. In this way, before the outer package packages, each of the high-side driving modules could be inspected in advance for troubleshooting. If any one of the high-side driving modules is found malfunctioned during inspection, only the malfunctioned high-side driving module that is packaged is required to be replaced, thereby reducing the cost due to malfunction. Moreover, as each of the high-side driving modules forms an individual component, the problem of the conventional power module that the yield rate of packaging is decreased and the packaging time is increased by integrally packaging three high-side driving circuits could be relieved.

### BRIEF DESCRIPTION OF THE DRAWINGS

The present invention will be best understood by referring to the following detailed description of some illustrative embodiments in conjunction with the accompanying drawings, in which
FIG. 1 is a schematic view showing the package structure of the driving device according to an embodiment of the present invention;
FIG. 2 is a schematic view of the high-side driving region of the driving device according to the embodiment of the present invention;
FIG. 3 is a perspective view of a marked region A1 in FIG. 1;
FIG. 4 is an exploded view of the structure shown in FIG. 3;

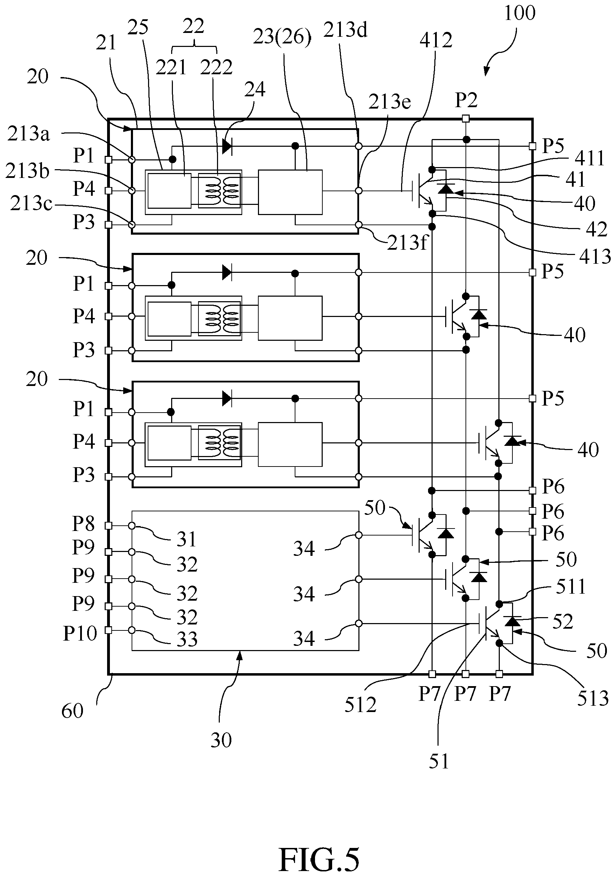

FIG. 5 is a schematic view showing a circuit diagram of the driving device according to the embodiment of the present invention; and

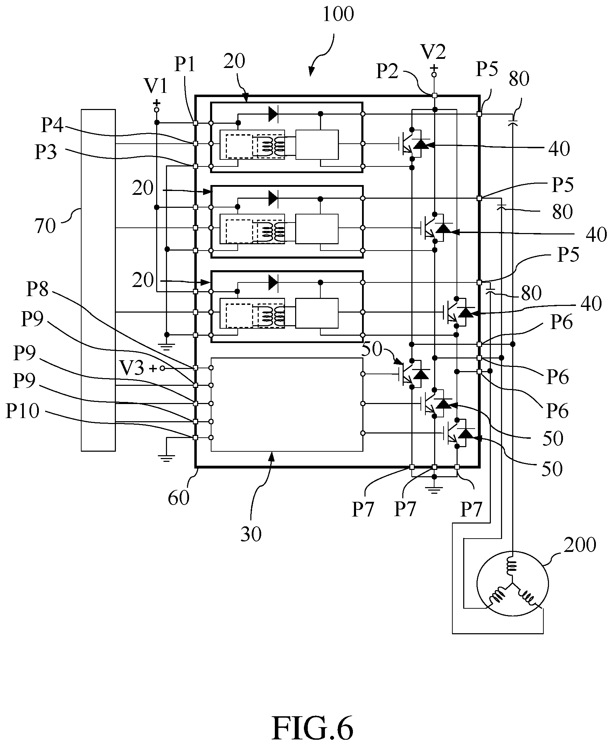

FIG. 6 is a schematic view showing the circuit diagram of the external connection of the driving device shown in FIG. 5.

### DETAILED DESCRIPTION OF THE INVENTION

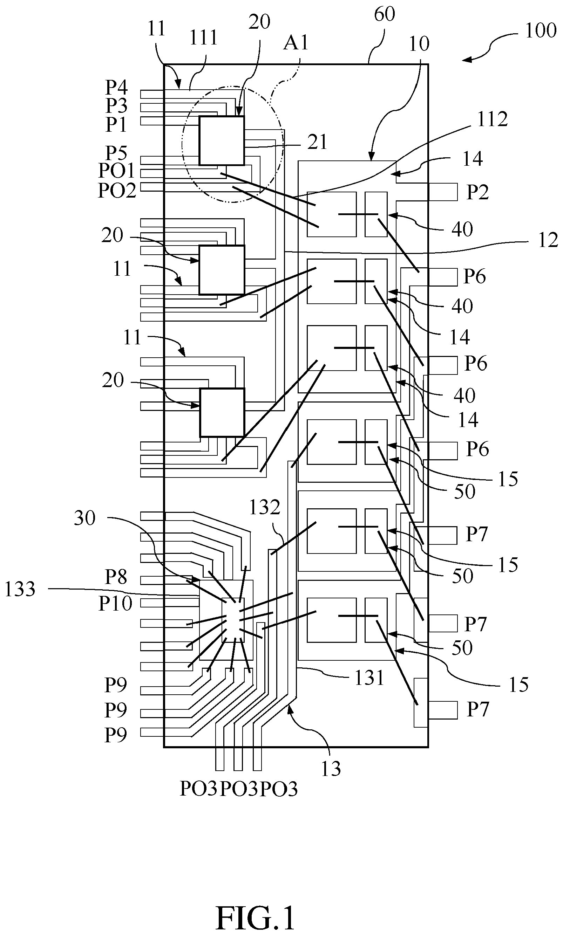

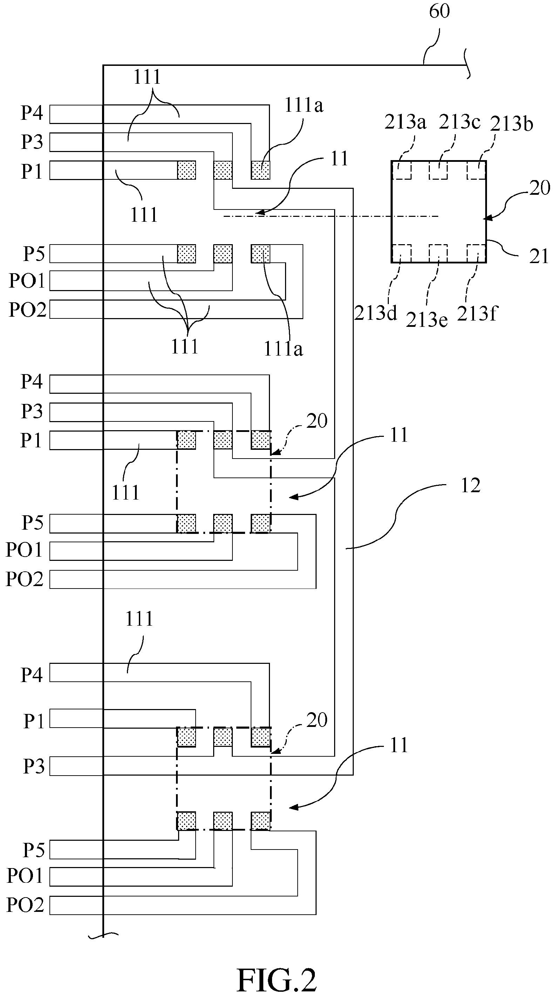

A driving device 100 according to an embodiment of the present invention is illustrated in FIG. 1 and FIG. 2 and includes a lead frame 10, a plurality of high-side driving modules 20, at least one low-side driving module 30, a plurality of high-side switching modules 40, a plurality of low-side switching modules 50, and an outer package 60. In the current embodiment, the number of the high-side driving modules 20, the number of the high-side switching modules 40, and the number of the low-side switching module 50 are respectively three, but not limited thereto. The high-side driving modules 20, the high-side switching modules 40, and the low-side switching module 50 are adapted to drive a motor, for example, a three-phase motor 200.

The lead frame 10 has a plurality of high-side driving regions 11, a connection linkage 12, at least one low-side driving region 13, a plurality of high-side switching regions 14, and a plurality of low-side switching regions 15. The high-side driving regions 11 and the high-side switching regions 14 are arranged side by side. The at least one low-side driving region 13 and the low-side switching regions 15 are arranged side by side. In the current embodiment, the number of the high-side driving regions 11 is three to correspond to three high-side driving modules 20, and the number of the at least one low-side driving region 13 is one to correspond to one low-side driving module 30, but not limited thereto.

Each of the high-side driving regions 11 includes a plurality of high-side linkages 111, wherein the high-side linkage 111 are arranged at intervals. Each of the high-side linkages 111 has a contact 111a, wherein the contact 111a is located on a terminal of the high-side linkage 111. The connection linkage 12 is located between the high-side driving regions 11 and the high-side switching regions 14. One of the high-side linkages 111 of each of the high-side driving regions 11 is connected to the connection linkage 12. In the current embodiment, each of the high-side switching modules 40 is connected to two of the high-side linkages 111 of each of the high-side driving regions 11 through two high-side metal wires 112 in a manner of wire bonding.

The low-side driving region 13 includes a plurality of low-side linkages 131 and at least one die pad 133. In the current embodiment, the number of the at least one die pad 133 is one, but not limited thereto. The low-side linkages 131 are arranged at intervals. The low-side driving module 30 is disposed on the die pad 133. The low-side driving module 30 are respectively connected to the low-side switching modules 50 and the low-side linkages 131 through a plurality of low-side metal wires 132 in a manner of wire bonding.

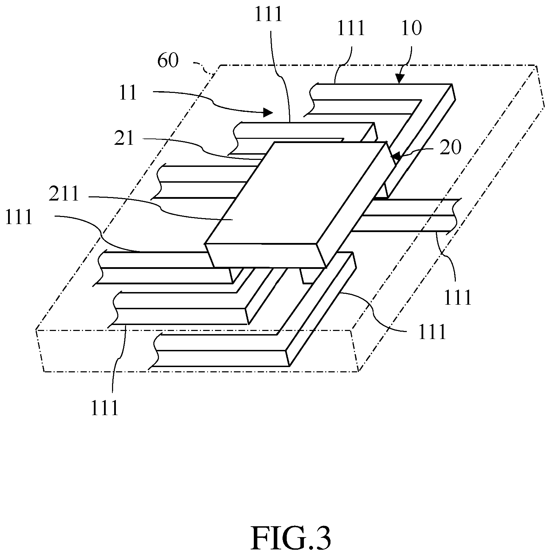

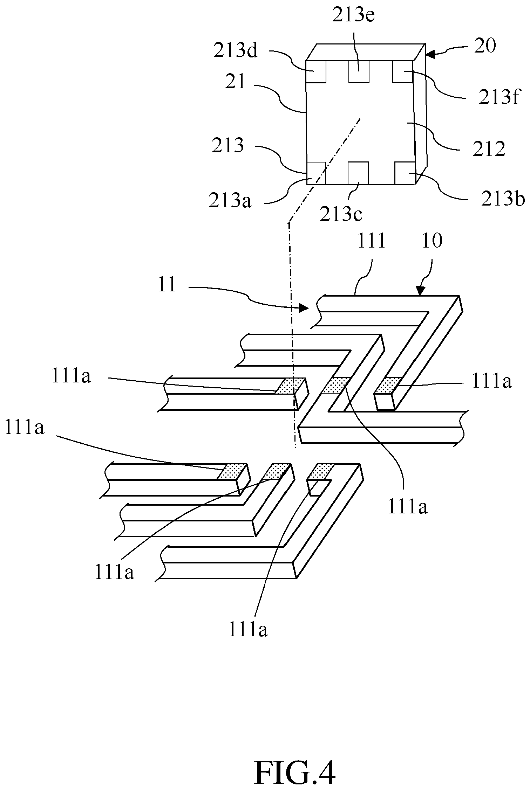

The three high-side driving modules 20 are respectively disposed in the high-side driving regions 11 of the lead frame 10. Each of the three high-side driving modules 20 includes a built-in package 21, a primary-side circuit 22, a drive-side circuit 23, and a bootstrap diode 24. The built-in package 21 packages the primary-side circuit 22, the drive-side circuit 23, and the bootstrap diode 24. As shown in FIG. 3 and FIG. 4, the built-in package 21 has a top surface 211 and a bottom surface 212. The bottom surface 212 is provided with a plurality of leads 213, wherein the leads 213 are electrically connected to the primary-side circuit 22, the drive-side circuit 23, and the bootstrap diode 24. The bottom surface 212 of each of the high-side driving modules 20 faces each of the high-side driving regions 11 of the lead frame 10. The leads 213 of each of the high-side driving modules 20 are correspondingly welded to each of the high-side driving regions 11 of the lead frame 10, wherein the leads 213 respectively correspond to the contacts 111a of the high-side linkages 111. In the current embodiment, the primary-side circuit 22 includes a control circuit 221 and an isolation circuit 222, wherein the isolation circuit 222 is configured to electrically isolate the control circuit 221 from the drive-side circuit 23, thereby preventing the drive-side circuit 23 from being affected by a high voltage of the control circuit 221.

In the current embodiment, the number of the built-in package 21 corresponds to the number of the high-side driving modules 20 to be three; the leads 213 of each of the built-in packages 21 are internal leads that are structures located on a bottom of a package body and not extending outward from the package body. However, the configuration of the built-in packages 21 is not limited thereto. In other embodiments, the configuration of the built-in packages 21 could be, for example, a Small OutLine Package (SOP).

Referring to FIG. 2, in the current embodiment, the driving device 100 further includes a plurality of external leads, wherein the external leads include a plurality of external first power leads P1, an external second power lead P2, a plurality of external first ground leads P3, a plurality of external high-side signal-input leads P4, a plurality of external connection leads P5, a plurality of external drive-output leads P6, and a plurality of external second ground leads P7. The external first power leads P1 are connected to a first power V1. The external second power lead P2 is connected to a second power V2. The external high-side signal-input leads P4 are connected to a microcontroller 70. The external first ground leads P3 are grounded. Each of the external connection leads P5 is electrically connected to a bootstrap capacitor 80. Each of the external drive-output leads P6 is electrically connected to each of the bootstrap capacitors 80 and the three-phase motor 200. The external second ground leads P7 are grounded. The numbers of the external first power leads P1, the external first ground leads P3, the external high-side signal-input leads P4, the external connection leads P5, the external drive-output leads P6, and the external second ground leads P7 could be adjusted to correspond to the number of the phase of the motor driven by the driving device 100.

Moreover, each of the three high-side driving modules 20 further has a first chip 25 and a second chip 26, wherein the first chip 25 has the primary-side circuit 22, and the second chip 26 has the drive-side circuit 23. The primary-side circuit 22 is electrically connected to the drive-side circuit 23. An anode of the bootstrap diode 24 is electrically connected to the primary-side circuit 22, and a cathode of the bootstrap diode 24 is electrically connected to the drive-side circuit 23.

Referring to FIG. 1, in the current embodiment, the structure and the function of the three high-side driving modules 20 are identical. In order to illustrate easily, one of the high-side driving modules 20 is used for illustration. The number of the leads 213 of the built-in package 21 is six, but not limited thereto. The six leads 213 are an internal first power lead 213a, an internal high-side signal-input lead 213b, an internal first ground lead 213c, an internal second power lead 213d, an internal high-side signal-output lead 213e, and an internal second ground lead 213f. The internal first power lead 213a is electrically connected to the primary-side circuit 22 and the anode of the bootstrap diode 24. The internal first power lead 213a is directly connected to the external first power lead P1 through one of the high-side linkages 111 that is corresponding. The internal high-side signal-input lead 213b is electrically connected to the primary-side circuit 22. More specifically, the internal high-side signal-input lead 213b is electrically connected to the control circuit 221 of the primary-side circuit 22. The internal high-side signal-input lead 213b is directly connected to the external high-side signal-input lead P4 through one of the high-side linkages 111 that is corresponding. The internal first ground lead 213c is electrically connected to the primary-side circuit 22. The internal first ground lead 213c is directly connected to the external first ground lead P3 through one of the high-side linkages 111 that is corresponding. The internal first ground lead 213c of one of the high-side driving modules 20 is connected to the internal first ground lead 213c of another one of the high-side driving modules 20 in a manner that the high-side linkage 111 corresponding to the internal first ground lead 213c of the high-side driving module 20 is connected to the connection linkage 12. The internal second power lead 213d is electrically connected to the cathode of the bootstrap diode 24 and the external connection lead P5. The internal high-side signal-output lead 213e is electrically connected to the drive-side circuit 23 and one of the high-side switching modules 40 that is corresponding. Additionally, in the current embodiment, the external leads of the driving device 100 further include a plurality of external high-side signal-output leads PO1 and a plurality of external fourth ground leads PO2. Each of the internal high-side signal-output leads 213e is connected to each of the external high-side signal-output leads PO1 through the corresponding high-side linkages 111 to detect an output signal of each of the high-side driving modules 20. The internal second ground lead 213f is electrically connected to the drive-side circuit 23, the corresponding high-side switching module 40, the low-side switching module 50, and the external drive-output lead P6. The internal second ground lead 213f of each of the high-side driving modules 20 is connected to each of the external fourth ground leads PO2 through the corresponding high-side linkages 111 to detect the output signal of each of the high-side driving modules 20. The external leads are connected to the corresponding high-side linkages 111 in a manner of integral connection. In the current embodiment, by the bootstrap diodes 24 and the bootstrap capacitors 80, a voltage of the three-phase motor 200 during switching phases could be increased, thereby achieving the purpose of accelerating the process of switching phases of the three-phase motor 200.

Additionally, in the current embodiment, the driving device 100 further includes an external third power lead P8, three external low-side signal-input leads P9, and an external third ground lead P10. The external third power lead P8 is connected to a third power V3. The external low-side signal-input leads P9 are connected to the microcontroller 70. The external third ground lead P10 is grounded. In the current embodiment, the number of the external low-side signal-input leads P9 corresponds to the number of the phases of the motor driven by the driving device 100.

In the current embodiment, the number of the at least one low-side driving module 30 is one, but not limited thereto. The low-side driving module 30 is disposed in the low-side driving region 13 of the lead frame 10. The low-side driving module 30 includes an internal power contact 31, three internal low-side signal-input contacts 32, an internal ground contact 33, and a plurality of internal low-side signal-output contacts 34. The internal power contact 31 is connected to the external third power lead P8 through one of the low-side linkages 131 that is corresponding. The three internal low-side signal-input contacts 32 are connected to the external low-side signal-input leads P9 through multiple of the low-side linkages 131 that are corresponding. The internal ground contact 33 is connected to the external third ground lead P10 through one of the low-side linkages 131 that is corresponding. The internal low-side signal-output contacts 34 are electrically connected to the low-side switching modules 50 that are corresponding. The number of the internal low-side signal-input contacts 32 and the number of the internal low-side signal-output contacts 34 respectively correspond to the number of the phase of the driven motor.

Additionally, in the current embodiment, the driving device 100 further includes a plurality of external low-side signal-output leads PO3, wherein the external low-side signal-output leads PO3 are connected to the low-side linkages 131, which are corresponding to the internal low-side signal-output contacts 34, to detect an output signal of the low-side driving module 30. The external low-side signal-output leads PO3 are connected to the low-side linkages 131, which are corresponding to the internal low-side signal-output contacts 34, in a manner of integral connection.

The high-side switching modules 40 are respectively disposed in the high-side switching regions 14 of the lead frame 10. In the current embodiment, the structure and the function of the three high-side switching modules 40 are identical. In order to illustrate easily, one of the high-side switching modules 40 is used for illustration. The high-side switching module 40 includes a first transistor 41 and a first diode 42. The first transistor 41 has a first end 411, a second end 412, and a third end 413. The first end 411 is electrically connected to the external second power lead P2 and a cathode of the first diode 42. The second end 412 is electrically connected to the internal high-side signal-output lead 213e through one of the high-side linkages 111 and one of the high-side metal wires 112 of the lead frame 10 that are corresponding. The third end 413 is electrically connected to an anode of the first diode 42, one of the external drive-output leads P6 that is corresponding, and is electrically connected to the internal second ground lead 213f through one of the high-side linkages 111 and one of the high-side metal wires 112 of the lead frame 10 that are corresponding. In the current embodiment, the first transistor 41 of each of the high-side switching modules 40 is an insulated-gate bipolar transistor, wherein the first end 411 is a collector of the insulated-gate bipolar transistor, the second end 412 is a gate of the insulated-gate bipolar transistor, and the third end 413 is an emitter of the insulated-gate bipolar transistor. In other embodiments, the first transistors 41 of the high-side switching modules 40 could be a switching element, such as a bipolar transistor or a metal-oxide-semiconductor field-effect transistor.

The three low-side switching modules 50 are respectively disposed in the low-side switching regions 15 of the lead frame 10. In the current embodiment, the structure and the function of the three low-side switching modules 50 are identical. In order to illustrate easily, one of the low-side switching modules 50 is used for illustration. The low-side switching module 50 includes a second transistor 51 and a second diode 52. The second transistor 51 has a fourth end 511, a fifth end 512, and a sixth end 513. The fourth end 511 is electrically connected to the third end 413 of the first transistor 41, a cathode of the second diode 52, and one of the external drive-output leads P6 that is corresponding. The fifth end 512 is electrically connected to one of the internal low-side signal-output contacts 34, which is corresponding, through one of the low-side linkages 131 and one of the low-side metal wires 132 of the lead frame 10 that are corresponding. The sixth end 513 is electrically connected to an anode of the second diode 52 and one of the external second ground leads P7 that is corresponding. In the current embodiment, the second transistor 51 of each of the low-side switching modules 50 is an insulated-gate bipolar transistor, wherein the fourth end 511 is a collector of the insulated-gate bipolar transistor, the fifth end 512 is a gate of the insulated-gate bipolar transistor, and the sixth end 513 is an emitter of the insulated-gate bipolar transistor. In other embodiments, the second transistors 51 of the low-side switching modules 50 could be a switching element such as a bipolar transistor or a metal-oxide-semiconductor field-effect transistor.

The outer package 60 packages the high-side driving modules 20, the low-side driving module 30, the high-side switching modules 40, the low-side switching modules 50 and the lead frame 10.

In other embodiments, the number of the at least one low-side driving module 30 could be adjusted to three without integration to meet different requirements and then the number of the at least one low-side driving region 13 is correspondingly adjusted, as long as the number of the low-side driving module 30 and the number of the low-side driving region 13 correspond to the number of the phases of the motor driven by the driving device 100. In practice, the number of the external second ground lead P7 could be at least one, wherein the at least one external second ground lead P7 is connected to the second transistors 51 and the second diodes 52 through a plurality of metal wires.

With the aforementioned design, each of the high-side driving modules 20 includes the built-in package 21 to packages the primary-side circuit 22, the drive-side circuit 23, and the bootstrap diode 24, so that the driving device 100 of the present invention achieves that each of the high-side driving modules 20 forms an individual component. In this way, before the outer package 60 packages, each of the high-side driving modules 20 could be inspected in advance for troubleshooting. When any one of the high-side driving modules 20 is found malfunctioned during inspection, only the malfunctioned high-side driving module 20 is required to be replaced, thereby reducing the cost due to malfunction. Moreover, as each of the high-side driving modules 20 forms an individual component, the problem of the conventional power module that the yield rate of packaging is decreased and the packaging time is increased by integrally packaging three high-side driving circuits could be relieved.

## Claims

1. A driving device (100), comprising:
a lead frame (10) having a plurality of high-side driving regions (11), at least one low-side driving region (13), a plurality of high-side switching regions (14), and a plurality of low-side switching regions (15);
a plurality of high-side driving modules (20) respectively disposed in the plurality of high-side driving regions (11) of the lead frame (10), wherein each of the plurality of high-side driving modules (20) comprises a built-in package (21), a primary-side circuit (22), a drive-side circuit (23), and a bootstrap diode (24); the built-in package (21) packages the primary-side circuit (22), the drive-side circuit (23), and the bootstrap diode (24); the built-in package (21) has a top surface (211) and a bottom surface (212); the bottom surface (212) is provided with a plurality of leads (213), wherein the plurality of leads (213) are electrically connected to the primary-side circuit (22), the drive-side circuit (23), and the bootstrap diode (24); the bottom surface (212) of each of the plurality of high-side driving modules (20) faces each of the plurality of high-side driving regions (11) of the lead frame (10); the plurality of leads (213) of each of the plurality of high-side driving modules (20) are welded to each of the plurality of high-side driving regions (11) of the lead frame (10);
at least one low-side driving module (30) disposed in the at least one low-side driving region (13) of the lead frame (10);
a plurality of high-side switching modules (40) respectively disposed in the plurality of high-side switching regions (14) of the lead frame (10); wherein each of the plurality of high-side switching modules (40) is electrically connected to each of the plurality of high-side driving modules (20) through the lead frame (10);
a plurality of low-side switching modules (50) respectively disposed in the plurality of low-side switching regions (15) of the lead frame (10), wherein the plurality of low-side switching modules (50) are electrically connected to the at least one low-side driving module (30) through the lead frame (10); and
an outer package (60) packaging the plurality of high-side driving modules (20), the at least one low-side driving module (30), the plurality of high-side switching modules (40), the plurality of low-side switching modules (50), and the lead frame (10).

2. The driving device (100) as claimed in claim 1, wherein each of the plurality of high-side driving regions (11) comprises a plurality of high-side linkages (111); the plurality of high-side linkages (111) are arranged at intervals; each of the plurality of high-side linkages (111) has a contact (111a); each of the plurality of leads (213) of each of the plurality of high-side driving modules (20) is welded to the contact (111a) of each of the plurality of high-side linkages (111).

3. The driving device (100) as claimed in claim 2, wherein each of the plurality of high-side switching modules (40) is connected to multiple of the plurality of high-side linkages (111) of each of the plurality of high-side driving regions (11) through a plurality of high-side metal wires (112).

4. The driving device (100) as claimed in claim 1, wherein the at least one low-side driving region (13) comprises a plurality of low-side linkages (131) and at least one die pad (133); the plurality of low-side linkages (131) are arranged at intervals; the at least one low-side driving module (30) is disposed on the at least one die pad (133); the at least one low-side driving module (30) is respectively connected to the plurality of low-side switching modules (50) and the plurality of low-side linkages (131) through a plurality of low-side metal wires (132).

5. The driving device (100) as claimed in claim 1, wherein each of the plurality of high-side driving modules (20) has a first chip (25) and a second chip (26); the first chip (25) has the primary-side circuit (22); the second chip (26) has the drive-side circuit (23); the primary-side circuit (22) is electrically connected to the drive-side circuit (23); the bootstrap diode (24) is electrically connected to the primary-side circuit (22) and the drive-side circuit (23).

6. The driving device (100) as claimed in claim 2, further comprising a plurality of external leads, wherein the plurality of external leads comprise a plurality of external first power leads (P1), a plurality of external high-side signal-input leads (P4), and a plurality of external first ground leads (P3); the lead frame (10) comprises a connection linkage (12), wherein the connection linkage (12) is connected to one of the plurality of high-side linkages (111) of each of the plurality of high-side driving regions (11); the plurality of leads (213) of each of the plurality of high-side driving modules (20) comprise an internal first power lead (213a), an internal high-side signal-input lead (213b), and an internal first ground lead (213c); the internal first power lead (213a) is electrically connected to the primary-side circuit (22); the internal first power lead (213a) of each of the plurality of high-side driving modules (20) is connected to each of the plurality of external first power leads (P1) through one of the plurality of high-side linkages (111) that is corresponding to the internal first power lead (213a); the internal high-side signal-input lead (213b) is electrically connected to the primary-side circuit (22); the internal high-side signal-input lead (213b) of each of the plurality of high-side driving modules (20) is connected to each of the plurality of external high-side signal-input leads (P4) through one of the plurality of high-side linkages (111) that is corresponding to the internal high-side signal-input lead (213b); the internal first ground lead (213c) of each of the plurality of high-side driving modules (20) is electrically connected to the primary-side circuit (22); the internal first ground lead (213c) of each of the plurality of high-side driving modules (20) is connected to each of the plurality of external first ground leads (P3) through one of the plurality of high-side linkages (111) that is corresponding to the internal first ground lead (213c); the internal first ground lead (213c) of each of the plurality of high-side driving modules (20) is electrically connected to the internal first ground lead (213c) of others of the plurality of high-side driving modules (20) through the connection linkage (12) and the high-side linkage (111) corresponding to the internal first ground lead (213c).

7. The driving device (100) as claimed in claim 2, further comprising a plurality of external leads, wherein the plurality of external leads comprise a plurality of external connection leads (P5); the plurality of external connection leads (P5) are configured to be electrically connected to a plurality of bootstrap capacitors (80); the plurality of leads (213) of each of the plurality of high-side driving modules (20) comprise an internal second power lead (213d); the internal second power lead (213d) of each of the plurality of high-side driving modules (20) is electrically connected to the bootstrap diode (24) of each of the plurality of high-side driving modules (20) and is connected to each of the plurality of external connection leads (P5) through one of the plurality of high-side linkages (111) that is corresponding.

8. The driving device (100) as claimed in claim 7, wherein the plurality of external leads comprise an external second power lead (P2) and a plurality of external drive-output leads (P6); the plurality of leads (213) of each of the plurality of high-side driving modules (20) comprise an internal high-side signal-output lead (213e); each of the plurality of high-side switching modules (40) comprises a first transistor (41) and a first diode (42); the first transistor (41) has a first end (411), a second end (412), and a third end (413); the first end (411) is electrically connected to the external second power lead (P2) and the first diode (42); the second end (412) is electrically connected to the internal high-side signal-output lead (213e) of one of the plurality of high-side driving modules (20) through a high-side metal wire (112) and one of the plurality of high-side linkages (111); the third end (413) is electrically connected to the first diode (42) and one of the plurality of external drive-output leads (P6); two ends of each of the plurality of bootstrap capacitors (80) are respectively and electrically connected to each of the plurality of external connection leads (P5) and each of the plurality of external drive-output leads (P6).

9. The driving device (100) as claimed in claim 8, wherein the plurality of external leads comprises at least one external second ground lead (P7); the at least one low-side driving module (30) has a plurality of internal low-side signal-output contacts (34); each of the plurality of low-side switching modules (50) comprises a second transistor (51) and a second diode (52); the second transistor (51) has a fourth end (511), a fifth end (512), and a sixth end (513); the fourth end (511) is electrically connected to the second diode (52), one of the plurality of external drive-output leads (P6), and the third end (413) of the first transistor (41) of one of the plurality of high-side switching modules (40) that is corresponding; the fifth end (512) is electrically connected to one of the plurality of internal low-side signal-output contacts (34); the sixth end (513) is electrically connected to the second diode (52) and the at least one external second ground lead (P7).

10. The driving device (100) as claimed in claim 9, wherein the plurality of leads (213) of each of the plurality of high-side driving modules (20) comprise an internal second ground lead (213f); the internal second ground lead (213f) is electrically connected to the drive-side circuit (23); the internal second ground lead (213f) of each of the plurality of high-side driving modules (20) is electrically connected to the third end (413) of the first transistor (41) of each of the plurality of high-side switching modules (40) through a high-side metal wire (112) and one of the plurality of high-side linkages (111) that is corresponding.

11. The driving device (100) as claimed in claim 10, wherein the plurality of external leads comprise a plurality of external output leads, the internal high-side signal-output lead (213e) and the internal second ground lead (213f) of each of the plurality of high-side driving modules (20) are respectively connected to two of the plurality of external output leads through two of the plurality of high-side linkages (111) that are corresponding.

## Patentansprüche

1. Antriebsvorrichtung (100), umfassend:
ein Leadframe (10) mit einer Vielzahl von High-Side-Antriebsbereichen (11), mindestens einem Low-Side-Antriebsbereich (13), einer Vielzahl von High-Side-Schaltbereichen (14) und einer Vielzahl von Low-Side-Schaltbereichen (15);
eine Vielzahl von High-Side-Antriebsmodulen (20), die jeweils in den High-Side-Antriebsbereichen (11) des Leadframes (10) angeordnet sind, wobei jedes der High-Side-Antriebsmodule (20) ein integriertes Gehäuse (21), eine Primärseitenschaltung (22), eine Antriebsseitenschaltung (23) und eine Bootstrap-Diode (24) umfasst; das integrierte Gehäuse (21) umschließt die Primärseitenschaltung (22), die Antriebsseitenschaltung (23) und die Bootstrap-Diode (24); das integrierte Gehäuse (21) weist eine Oberseite (211) und eine Unterseite (212) auf; an der Unterseite (212) ist eine Vielzahl von Anschlussleitern (213) vorgesehen, wobei die Vielzahl von Anschlussleitern (213) elektrisch mit der Primärseitenschaltung (22), der Antriebsseitenschaltung (23) und der Bootstrap-Diode (24) verbunden ist; die Unterseite (212) jedes der High-Side-Antriebsmodule (20) ist den jeweiligen High-Side-Antriebsbereichen (11) des Leadframes (10) zugewandt; die Vielzahl von Anschlussleitern (213) jedes der High-Side-Antriebsmodule (20) ist mit den jeweiligen High-Side-Antriebsbereichen (11) des Leadframes (10) verlötet;
mindestens ein Low-Side-Antriebsmodul (30), das in dem mindestens einen Low-Side-Antriebsbereich (13) des Leadframes (10) angeordnet ist;
eine Vielzahl von High-Side-Schaltmodulen (40), die jeweils in den High-Side-Schaltbereichen (14) des Leadframes (10) angeordnet sind, wobei jedes der High-Side-Schaltmodule (40) über das Leadframe (10) elektrisch mit jedem der High-Side-Antriebsmodule (20) verbunden ist;
eine Vielzahl von Low-Side-Schaltmodulen (50), die jeweils in den Low-Side-Schaltbereichen (15) des Leadframes (10) angeordnet sind, wobei die Vielzahl von Low-Side-Schaltmodulen (50) über das Leadframe (10) elektrisch mit dem mindestens einen Low-Side-Antriebsmodul (30) verbunden ist; und
ein Außengehäuse (60), das die Vielzahl von High-Side-Antriebsmodulen (20), das mindestens eine Low-Side-Antriebsmodul (30), die Vielzahl von High-Side-Schaltmodulen (40), die Vielzahl von Low-Side-Schaltmodulen (50) und das Leadframe (10) umschließt.

2. Die Antriebsvorrichtung (100), nach Anspruch 1, wobei jeder der High-Side-Antriebsbereiche (11) eine Vielzahl von High-Side-Verbindungsabschnitten (111) umfasst; die Vielzahl von High-Side-Verbindungsabschnitten (111) ist mit Abstand angeordnet; jeder der High-Side-Verbindungsabschnitte (111) weist einen Kontakt (111a) auf; jeder der Anschlussleiter (213) jedes der High-Side-Antriebsmodule (20) ist mit dem Kontakt (111a) jedes der High-Side-Verbindungsabschnitte (111) verlötet.

3. Die Antriebsvorrichtung (100), nach Anspruch 2, wobei jedes der High-Side-Schaltmodule (40) über eine Vielzahl von High-Side-Metallleitungen (112) mit mehreren der High-Side-Verbindungsabschnitte (111) jedes der High-Side-Antriebsbereiche (11) verbunden ist.

4. Die Antriebsvorrichtung (100), nach Anspruch 1, wobei der mindestens eine Low-Side-Antriebsbereich (13) eine Vielzahl von Low-Side-Verbindungsabschnitten (131) und mindestens eine Die-Pad-Fläche (133) umfasst; die Vielzahl von Low-Side-Verbindungsabschnitten (131) ist mit Abstand angeordnet; das mindestens eine Low-Side-Antriebsmodul (30) ist auf der mindestens einen Die-Pad-Fläche (133) angeordnet; das mindestens eine Low-Side-Antriebsmodul (30) ist jeweils über eine Vielzahl von Low-Side-Metallleitungen (132) mit der Vielzahl von Low-Side-Schaltmodulen (50) und der Vielzahl von Low-Side-Verbindungsabschnitten (131) verbunden.

5. Die Antriebsvorrichtung (100), nach Anspruch 1, wobei jedes der High-Side-Antriebsmodule (20) einen ersten Chip (25) und einen zweiten Chip (26) aufweist; der erste Chip (25) trägt die Primärseitenschaltung (22); der zweite Chip (26) trägt die Antriebsseitenschaltung (23); die Primärseitenschaltung (22) ist elektrisch mit der Antriebsseitenschaltung (23) verbunden; die Bootstrap-Diode (24) ist elektrisch mit der Primärseitenschaltung (22) und der Antriebsseitenschaltung (23) verbunden.

6. Die Antriebsvorrichtung (100), nach Anspruch 2, ferner umfassend eine Vielzahl von externen Anschlussleitern, wobei die Vielzahl von externen Anschlussleitern eine Vielzahl von externen ersten Versorgungsleitern (P1), eine Vielzahl von externen High-Side-Signaleingangsleitern (P4) und eine Vielzahl von externen ersten Masseleitern (P3) umfasst; das Leadframe (10) umfasst einen Verbindungsabschnitt (12), wobei der Verbindungsabschnitt (12) mit einem der High-Side-Verbindungsabschnitte (111) jedes der High-Side-Antriebsbereiche (11) verbunden ist; die Vielzahl von Anschlussleitern (213) jedes der High-Side-Antriebsmodule (20) umfasst einen internen ersten Versorgungsleiter (213a), einen internen High-Side-Signaleingangsleiter (213b) und einen internen ersten Masseleiter (213c); der interne erste Versorgungsleiter (213a) ist elektrisch mit der Primärseitenschaltung (22) verbunden; der interne erste Versorgungsleiter (213a) jedes der High-Side-Antriebsmodule (20) ist über einen der High-Side-Verbindungsabschnitte (111), der dem internen ersten Versorgungsleiter (213a) entspricht, mit jedem der externen ersten Versorgungsleiter (P1) verbunden; der interne High-Side-Signaleingangsleiter (213b) ist elektrisch mit der Primärseitenschaltung (22) verbunden; der interne High-Side-Signaleingangsleiter (213b) jedes der High-Side-Antriebsmodule (20) ist über einen der High-Side-Verbindungsabschnitte (111), der dem internen High-Side-Signaleingangsleiter (213b) entspricht, mit jedem der externen High-Side-Signaleingangsleiter (P4) verbunden; der interne erste Masseleiter (213c) jedes der High-Side-Antriebsmodule (20) ist elektrisch mit der Primärseitenschaltung (22) verbunden; der interne erste Masseleiter (213c) jedes der High-Side-Antriebsmodule (20) ist über einen der High-Side-Verbindungsabschnitte (111), der dem internen ersten Masseleiter (213c) entspricht, mit jedem der externen ersten Masseleiter (P3) verbunden; der interne erste Masseleiter (213c) jedes der High-Side-Antriebsmodule (20) ist über den Verbindungsabschnitt (12) und den dem internen ersten Masseleiter (213c) entsprechenden High-Side-Verbindungsabschnitt (111) elektrisch mit dem internen ersten Masseleiter (213c) der übrigen High-Side-Antriebsmodule (20) verbunden.

7. Die Antriebsvorrichtung (100), nach Anspruch 2, ferner umfassend eine Vielzahl von externen Anschlussleitern, wobei die Vielzahl von externen Anschlussleitern eine Vielzahl von externen Verbindungsleitern (P5) umfasst; die Vielzahl von externen Verbindungsleitern (P5) ist dazu eingerichtet, elektrisch mit einer Vielzahl von Bootstrap-Kondensatoren (80) verbunden zu werden; die Vielzahl von Anschlussleitern (213) jedes der High-Side-Antriebsmodule (20) umfasst einen internen zweiten Versorgungsleiter (213d); der interne zweite Versorgungsleiter (213d) jedes der High-Side-Antriebsmodule (20) ist elektrisch mit der Bootstrap-Diode (24) jedes der High-Side-Antriebsmodule (20) verbunden und über einen der High-Side-Verbindungsabschnitte (111), der entsprechend ist, mit jedem der externen Verbindungsleiter (P5) verbunden.

8. Die Antriebsvorrichtung (100), nach Anspruch 7, wobei die Vielzahl von externen Anschlussleitern einen externen zweiten Versorgungsleiter (P2) und eine Vielzahl von externen Antriebsausgangsleitern (P6) umfasst; die Vielzahl von Anschlussleitern (213) jedes der High-Side-Antriebsmodule (20) umfasst einen internen High-Side-Signalausgangsleiter (213e); jedes der High-Side-Schaltmodule (40) umfasst einen ersten Transistor (41) und eine erste Diode (42); der erste Transistor (41) weist einen ersten Anschluss (411), einen zweiten Anschluss (412) und einen dritten Anschluss (413) auf; der erste Anschluss (411) ist elektrisch mit dem externen zweiten Versorgungsleiter (P2) und der ersten Diode (42) verbunden; der zweite Anschluss (412) ist über eine High-Side-Metallleitung (112) und einen der High-Side-Verbindungsabschnitte (111) elektrisch mit dem internen High-Side-Signalausgangsleiter (213e) eines der High-Side-Antriebsmodule (20) verbunden; der dritte Anschluss (413) ist elektrisch mit der ersten Diode (42) und einem der externen Antriebsausgangsleiter (P6) verbunden; zwei Anschlüsse jedes der Bootstrap-Kondensatoren (80) sind jeweils elektrisch mit jedem der externen Verbindungsleiter (P5) und jedem der externen Antriebsausgangsleiter (P6) verbunden.

9. Die Antriebsvorrichtung (100), nach Anspruch 8, wobei die Vielzahl von externen Anschlussleitern mindestens einen externen zweiten Masseleiter (P7) umfasst; das mindestens eine Low-Side-Antriebsmodul (30) weist eine Vielzahl von internen Low-Side-Signalausgangskontakten (34) auf; jedes der Low-Side-Schaltmodule (50) umfasst einen zweiten Transistor (51) und eine zweite Diode (52); der zweite Transistor (51) weist einen vierten Anschluss (511), einen fünften Anschluss (512) und einen sechsten Anschluss (513) auf; der vierte Anschluss (511) ist elektrisch mit der zweiten Diode (52), einem der externen Antriebsausgangsleiter (P6) und dem dritten Anschluss (413) des ersten Transistors (41) eines der entsprechenden High-Side-Schaltmodule (40) verbunden; der fünfte Anschluss (512) ist elektrisch mit einem der internen Low-Side-Signalausgangskontakte (34) verbunden; der sechste Anschluss (513) ist elektrisch mit der zweiten Diode (52) und dem mindestens einen externen zweiten Masseleiter (P7) verbunden.

10. Die Antriebsvorrichtung (100), nach Anspruch 9, wobei die Vielzahl von Anschlussleitern (213) jedes der High-Side-Antriebsmodule (20) einen internen zweiten Masseleiter (213f) umfasst; der interne zweite Masseleiter (213f) ist elektrisch mit der Antriebsseitenschaltung (23) verbunden; der interne zweite Masseleiter (213f) jedes der High-Side-Antriebsmodule (20) ist über eine High-Side-Metallleitung (112) und einen der entsprechenden High-Side-Verbindungsabschnitte (111) elektrisch mit dem dritten Anschluss (413) des ersten Transistors (41) jedes der High-Side-Schaltmodule (40) verbunden.

11. Die Antriebsvorrichtung (100), nach Anspruch 10, wobei die Vielzahl von externen Anschlussleitern eine Vielzahl von externen Ausgangsleitern umfasst, wobei der interne High-Side-Signalausgangsleiter (213e) und der interne zweite Masseleiter (213f) jedes der High-Side-Antriebsmodule (20) jeweils über zwei der entsprechenden High-Side-Verbindungsabschnitte (111) mit zwei der externen Ausgangsleiter verbunden sind.

## Revendications

1. Dispositif de pilotage (100), comprenant:
une grille de connexion (10) ayant une pluralité de régions de pilotage côté haut (11), au moins une région de pilotage côté bas (13), une pluralité de régions de commutation côté haut (14) et une pluralité de régions de commutation côté bas (15);
une pluralité de modules de pilotage côté haut (20) disposés respectivement dans la pluralité de régions de pilotage côté haut (11) de la grille de connexion (10), chacun de la pluralité de modules de pilotage côté haut (20) comprenant un boîtier intégré (21), un circuit côté primaire (22), un circuit côté pilotage (23) et une diode d'amorçage (24); le boîtier intégré (21) encapsulant le circuit côté primaire (22), le circuit côté pilotage (23) et la diode d'amorçage (24); le boîtier intégré (21) ayant une surface supérieure (211) et une surface inférieure (212); la surface inférieure (212) comportant une pluralité de conducteurs (213), la pluralité de conducteurs (213) étant reliée électriquement au circuit côté primaire (22), au circuit côté pilotage (23) et à la diode d'amorçage (24); la surface inférieure (212) de chacun de la pluralité de modules de pilotage côté haut (20) faisant face à chacune de la pluralité de régions de pilotage côté haut (11) de la grille de connexion (10); la pluralité de conducteurs (213) de chacun de la pluralité de modules de pilotage côté haut (20) étant soudés à chacune de la pluralité de régions de pilotage côté haut (11) de la grille de connexion (10);
au moins un module de pilotage côté bas (30) disposé dans l'au moins une région de pilotage côté bas (13) de la grille de connexion (10);
une pluralité de modules de commutation côté haut (40) disposés respectivement dans la pluralité de régions de commutation côté haut (14) de la grille de connexion (10); chacun de la pluralité de modules de commutation côté haut (40) étant relié électriquement à chacun de la pluralité de modules de pilotage côté haut (20) par l'intermédiaire de la grille de connexion (10);
une pluralité de modules de commutation côté bas (50) disposés respectivement dans la pluralité de régions de commutation côté bas (15) de la grille de connexion (10), la pluralité de modules de commutation côté bas (50) étant reliés électriquement à l'au moins un module de pilotage côté bas (30) par l'intermédiaire de la grille de connexion (10); et
un boîtier extérieur (60) encapsulant la pluralité de modules de pilotage côté haut (20), l'au moins un module de pilotage côté bas (30), la pluralité de modules de commutation côté haut (40), la pluralité de modules de commutation côté bas (50) et la grille de connexion (10).

2. Dispositif de pilotage (100) selon la revendication 1, dans lequel chacune de la pluralité de régions de pilotage côté haut (11) comprend une pluralité de liaisons côté haut (111); la pluralité de liaisons côté haut (111) sont disposées à intervalles; chacune de la pluralité de liaisons côté haut (111) ayant un contact (111a); chacun de la pluralité de conducteurs (213) de chacun de la pluralité de modules de pilotage côté haut (20) est soudé au contact (111a) de chacune de la pluralité de liaisons côté haut (111).

3. Dispositif de pilotage (100) selon la revendication 2, dans lequel chacun de la pluralité de modules de commutation côté haut (40) est relié à plusieurs de la pluralité de liaisons côté haut (111) de chacune de la pluralité de régions de pilotage côté haut (11) par l'intermédiaire d'une pluralité de fils métalliques côté haut (112).

4. Dispositif de pilotage (100) selon la revendication 1, dans lequel l'au moins une région de pilotage côté bas (13) comprend une pluralité de liaisons côté bas (131) et au moins une pastille de puce (133); la pluralité de liaisons côté bas (131) sont disposées à intervalles; l'au moins un module de pilotage côté bas (30) est disposé sur l'au moins une pastille de puce (133); l'au moins un module de pilotage côté bas (30) est respectivement connecté à la pluralité de modules de commutation côté bas (50) et à la pluralité de liaisons côté bas (131) par l'intermédiaire d'une pluralité de fils métalliques côté bas (132).

5. Dispositif de pilotage (100) selon la revendication 1, dans lequel chacun de la pluralité de modules de pilotage côté haut (20) possède une première puce (25) et une seconde puce (26); la première puce (25) comporte le circuit côté primaire (22); la seconde puce (26) comporte le circuit côté pilotage (23); le circuit côté primaire (22) est relié électriquement au circuit côté pilotage (23); la diode d'amorçage (24) est reliée électriquement au circuit côté primaire (22) et au circuit côté pilotage (23).

6. Dispositif de pilotage (100) selon la revendication 2, comprenant en outre une pluralité de conducteurs externes, dans lequel la pluralité de conducteurs externes comprend une pluralité de premiers conducteurs d'alimentation externes (P1), une pluralité de conducteurs d'entrée de signal côté haut externes (P4) et une pluralité de premiers conducteurs de masse externes (P3); la grille de connexion (10) comprend une liaison de connexion (12), la liaison de connexion (12) étant reliée à l'une de la pluralité de liaisons côté haut (111) de chacune de la pluralité de régions de pilotage côté haut (11); la pluralité de conducteurs (213) de chacun de la pluralité de modules de pilotage côté haut (20) comprend un premier conducteur d'alimentation interne (213a), un conducteur d'entrée de signal côté haut interne (213b) et un premier conducteur de masse interne (213c); le premier conducteur d'alimentation interne (213a) est relié électriquement au circuit côté primaire (22); le premier conducteur d'alimentation interne (213a) de chacun de la pluralité de modules de pilotage côté haut (20) est relié à chacun de la pluralité de premiers conducteurs d'alimentation externes (P1) par l'intermédiaire de l'une de la pluralité de liaisons côté haut (111) qui correspond au premier conducteur d'alimentation interne (213a); le conducteur d'entrée de signal côté haut interne (213b) est relié électriquement au circuit côté primaire (22); le conducteur d'entrée de signal côté haut interne (213b) de chacun de la pluralité de modules de pilotage côté haut (20) est relié à chacun de la pluralité de conducteurs d'entrée de signal côté haut externes (P4) par l'intermédiaire de l'une de la pluralité de liaisons côté haut (111) qui correspond au conducteur d'entrée de signal côté haut interne (213b); le premier conducteur de masse interne (213c) de chacun de la pluralité de modules de pilotage côté haut (20) est relié électriquement au circuit côté primaire (22); le premier conducteur de masse interne (213c) de chacun de la pluralité de modules de pilotage côté haut (20) est relié à chacun de la pluralité de premiers conducteurs de masse externes (P3) par l'intermédiaire de l'une de la pluralité de liaisons côté haut (111) qui correspond au premier conducteur de masse interne (213c); le premier conducteur de masse interne (213c) de chacun de la pluralité de modules de pilotage côté haut (20) est relié électriquement au premier conducteur de masse interne (213c) des autres de la pluralité de modules de pilotage côté haut (20) par l'intermédiaire de la liaison de connexion (12) et de la liaison côté haut (111) correspondant au premier conducteur de masse interne (213c).

7. Dispositif de pilotage (100) selon la revendication 2, comprenant en outre une pluralité de conducteurs externes, la pluralité de conducteurs externes comprenant une pluralité de conducteurs de connexion externes (P5); la pluralité de conducteurs de connexion externes (P5) étant configurés pour être reliés électriquement à une pluralité de condensateurs d'amorçage (80); la pluralité de conducteurs (213) de chacun de la pluralité de modules de pilotage côté haut (20) comprenant un second conducteur d'alimentation interne (213d); le second conducteur d'alimentation interne (213d) de chacun de la pluralité de modules de pilotage côté haut (20) étant relié électriquement à la diode d'amorçage (24) de chacun de la pluralité de modules de pilotage côté haut (20) et étant relié à chacun de la pluralité de conducteurs de connexion externes (P5) par l'intermédiaire de l'une de la pluralité de liaisons côté haut (111) qui correspond.

8. Dispositif de pilotage (100) selon la revendication 7, dans lequel la pluralité de conducteurs externes comprend un second conducteur d'alimentation externe (P2) et une pluralité de conducteurs de sortie de pilotage externes (P6); la pluralité de conducteurs (213) de chacun de la pluralité de modules de pilotage côté haut (20) comprenant un conducteur de sortie de signal côté haut interne (213e); chacun de la pluralité de modules de commutation côté haut (40) comprenant un premier transistor (41) et une première diode (42); le premier transistor (41) comportant une première extrémité (411), une deuxième extrémité (412) et une troisième extrémité (413); la première extrémité (411) étant reliée électriquement au second conducteur d'alimentation externe (P2) et à la première diode (42); la deuxième extrémité (412) étant reliée électriquement au conducteur de sortie de signal côté haut interne (213e) de l'un de la pluralité de modules de pilotage côté haut (20) par l'intermédiaire d'un fil métallique côté haut (112) et de l'une de la pluralité de liaisons côté haut (111); la troisième extrémité (413) étant reliée électriquement à la première diode (42) et à l'un de la pluralité de conducteurs de sortie de pilotage externes (P6); deux extrémités de chacun de la pluralité de condensateurs d'amorçage (80) étant respectivement et électriquement reliées à chacun de la pluralité de conducteurs de connexion externes (P5) et à chacun de la pluralité de conducteurs de sortie de pilotage externes (P6).

9. Dispositif de pilotage (100) selon la revendication 8, dans lequel la pluralité de conducteurs externes comprend au moins un second conducteur de masse externe (P7); l'au moins un module de pilotage côté bas (30) comporte une pluralité de contacts internes de sortie de signal côté bas (34); chacun de la pluralité de modules de commutation côté bas (50) comprend un second transistor (51) et une seconde diode (52); le second transistor (51) comporte une quatrième extrémité (511), une cinquième extrémité (512) et une sixième extrémité (513); la quatrième extrémité (511) est reliée électriquement à la seconde diode (52), à l'un de la pluralité de conducteurs de sortie de pilotage externes (P6) et à la troisième extrémité (413) du premier transistor (41) de l'un de la pluralité de modules de commutation côté haut (40) qui correspond; la cinquième extrémité (512) est reliée électriquement à l'un de la pluralité de contacts de sortie de signal côté bas internes (34); la sixième extrémité (513) est reliée électriquement à la seconde diode (52) et à l'au moins un second conducteur de masse externe (P7).

10. Dispositif de pilotage (100) selon la revendication 9, dans lequel la pluralité de conducteurs (213) de chacun de la pluralité de modules de pilotage côté haut (20) comprend un second conducteur de masse interne (213f); le second conducteur de masse interne (213f) est relié électriquement au circuit côté pilotage (23); le second conducteur de masse interne (213f) de chacun de la pluralité de modules de pilotage côté haut (20) est relié électriquement à la troisième extrémité (413) du premier transistor (41) de chacun de la pluralité de modules de commutation côté haut (40) par l'intermédiaire d'un fil métallique côté haut (112) et de l'une de la pluralité de liaisons côté haut (111) qui correspond.

11. Dispositif de pilotage (100) selon la revendication 10, dans lequel la pluralité de conducteurs externes comprend une pluralité de conducteurs de sortie externes, le conducteur de sortie de signal côté haut interne (213e) et le second conducteur de masse interne (213f) de chacun de la pluralité de modules de pilotage côté haut (20) sont respectivement reliés à deux de la pluralité de conducteurs de sortie externes par l'intermédiaire de deux de la pluralité de liaisons côté haut (111) qui correspondent.
